# DEMANDE DE BREVET EUROPEEN

(11) **EP 3 432 352 A1**
(43) Date de publication de la demande: **23.01.2019**
(21) Numéro de dépôt: 18183539.8
(22) Date de dépôt: 13.07.2018
(51) Int. Cl.: H01L 21/78, H01L 21/3065

(54) **PROCÉDÉ DE FABRICATION DE PUCES ISOLÉES LATÉRALEMENT**

(30) Priorité: 13.07.2017 FR 1756678
(71) Demandeur: STMicroelectronics (Tours) SAS, 37100 Tours (FR)
(72) Inventeur: ROUVIERE, Mathieu, 37000 TOURS (FR); BOUFNICHEL, Mohamed, 37380 MONNAIE (FR); LACONDE, Eric, 37100 TOURS (FR)
(74) Mandataire: Cabinet Beaumont

(57) **Abrégé**

L'invention concerne un procédé de fabrication de puces isolées (25) latéralement à partir d'une tranche semiconductrice, comprenant les étapes successives suivantes :
former des tranchées périphériques (33) délimitant latéralement les puces à former (25), de profondeur supérieure ou égale à l'épaisseur des puces (25), en répétant des étapes successives de gravure ionique utilisant un plasma d'hexafluorure de soufre et de passivation utilisant un plasma d'octafluorocyclobutane de façon que, à l'issue de l'étape de formation de la tranchée (33), les parois latérales de la tranchée (33) soient recouvertes d'une couche isolante d'un polyfluoroéthylène (35) ; et
amincir la tranche par sa face inférieure jusqu'à atteindre le fond de la tranchée (33) sans étape préalable de retrait de ladite couche isolante.

## Description

### Domaine

La présente demande concerne le domaine des puces électronique. Elle concerne plus particulièrement un procédé de fabrication d'une puce isolée latéralement.

### Exposé de l'art antérieur

De façon classique, une puce électronique comprend un ou plusieurs composants électroniques formés dans une tranche semiconductrice avant découpe de celle-ci, et, sur une face, une ou plusieurs métallisations de contact destinées à être brasées à un dispositif extérieur à la puce, par exemple une carte de circuit imprimé ou une autre puce.

Dans certaines applications, il existe un besoin pour des puces utilisables directement sans mise en boîtier, en particulier des diodes et plus particulièrement des diodes de protection, dans lesquelles les faces latérales ou flancs de la puce sont revêtues d'une couche électriquement isolante. Une telle isolation latérale de la puce permet notamment d'éviter, lorsque le brasage est réalisé, que d'éventuelles remontées de brasure sur les flancs de la puce n'introduisent des courts-circuits entre les électrodes et le substrat de la puce.

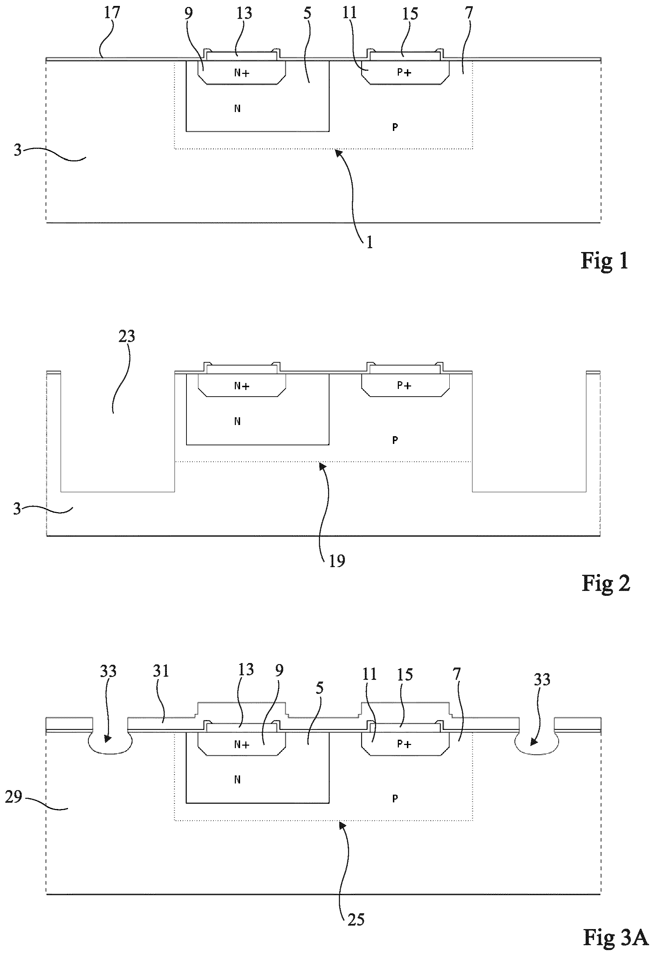

La figure 1 est une vue en coupe d'une diode 1 délimitée par des pointillés et formée à partir de la face supérieure d'une tranche semiconductrice 3, par exemple en silicium. A ce stade, la diode 1 est solidaire de la tranche 3.

La diode 1 est formée par un caisson dopé de type N 5 formée dans une région dopée de type P 7 de la tranche semiconductrice 3. Le caisson 5 est par exemple formé à partir de la face supérieure de la région 7.

Des régions de reprise de contact 9, 11 sont formées respectivement dans le caisson 5 et la région 7. La région 9 est dopée de type N et a un niveau de dopage N+ plus important que celui du caisson N. La région 11 est dopée de type P et a un niveau de dopage P+ plus important que celui de la région 7.

Des contacts de cathode et d'anode 13, 15 sont formés sur les régions de reprise de contact 9, 11. Le contact d'anode 15 est formé sur la région de reprise de contact 11 (à droite sur la figure 1). Le contact de cathode 13 est formé sur la région de reprise de contact 9 (à gauche sur la figure 1). Les contacts 13, 15 sont en un métal, en une superposition de métaux, ou en un alliage de différents métaux.

La face supérieure de cette structure, à l'exception des contacts 13, 15, est recouverte d'une couche de passivation 17.

En pratique, plusieurs diodes, ou d'autres composants électroniques, peuvent être réalisées simultanément à partir d'une même tranche semiconductrice 3. Par souci de simplification, une seule diode 1 est détaillée ici.

La figure 2 est une vue en coupe d'une étape d'un procédé de fabrication d'une puce 19 isolée latéralement. La puce 19 est une puce destinée à être utilisée sans boîtier. A titre d'exemple, la puce 19 comprend une diode identique à la diode 1 décrite en relation avec la figure 1.

A cette étape, une tranchée 23 entourant entièrement (en vue de dessus) la puce 19 est gravée. La tranchée 23 définit les faces latérales de la puce 19. La tranchée 23 s'étend dans la tranche 3 jusqu'à une profondeur supérieure ou égale à l'épaisseur désirée de la puce 19. La tranchée 23 est non traversante, c'est-à-dire qu'elle ne s'étend pas jusqu'à la face inférieure de la tranche 3.

De façon classique, la tranchée 23 est réalisée par un procédé de gravure ionique réactive profonde (DRIE) ou par un procédé de gravure dit procédé Bosch (procédé du type de celui décrit dans le brevet US5501893). Un tel procédé provoque l'apparition sur les parois de la tranchée 23 d'une couche de polymère. Cette couche de polymère est généralement considérée comme polluante. Ainsi le procédé de gravure est suivi d'une étape de nettoyage chimique supprimant la couche de polymère.

Par la suite, une couche isolante, par exemple en dioxyde de silicium, est déposée de façon conforme dans la tranchée 23 afin d'isoler les parois de la tranchée qui forment, comme dit précédemment, les parois latérales de la puce 19. La tranche semiconductrice 3 est ensuite meulée par sa face arrière afin d'individualiser la puce 19 en la séparant de la tranche 3.

On propose ici un procédé de fabrication d'une puce isolée latéralement minimisant son nombre d'étapes.

### Résumé

Ainsi, un mode de réalisation prévoit un procédé de fabrication de puces isolées latéralement à partir d'une tranche semiconductrice, comprenant les étapes successives suivantes :
former des tranchées périphériques délimitant latéralement les puces à former, de profondeur supérieure ou égale à l'épaisseur des puces, en répétant des étapes successives de gravure ionique utilisant un plasma d'hexafluorure de soufre et de passivation utilisant un plasma d'octafluorocyclobutane de façon que, à l'issue de l'étape de formation de la tranchée, les parois latérales de la tranchée soient recouvertes d'une couche isolante d'un polyfluoroéthylène ; et
amincir la tranche par sa face inférieure jusqu'à atteindre le fond de la tranchée sans étape préalable de retrait de ladite couche isolante.

Selon un mode de réalisation, la dernière étape de passivation a une durée supérieure aux précédentes d'au moins 50 %.

Selon un mode de réalisation, la dernière étape de passivation a une durée comprise entre 10 s et 7 minutes.

Selon un mode de réalisation, la couche isolante a une épaisseur comprise entre 100 nm et 3 µm.

Selon un mode de réalisation, la profondeur de la tranchée est supérieure à l'épaisseur des puces de 10 à 50 µm.

Selon un mode de réalisation, la tranchée a une largeur comprise entre 5 et 80 µm.

Un autre mode de réalisation prévoit une puce électronique comprenant : un substrat semiconducteur ; un ou plusieurs composants électroniques formés dans le substrat ; et une couche de polyfluoroéthylène isolante d'épaisseur comprise entre 100 nm et 3 µm recouvrant les faces latérales de la puce.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une vue en coupe d'une diode ;
la figure 2, décrite précédemment, est une vue en coupe d'une étape d'un procédé de fabrication d'une puce isolée latéralement ; et
les figures 3A à 3F sont des vues en coupe d'étapes d'un mode de réalisation d'un procédé de fabrication d'une puce isolée latéralement.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les divers composants électroniques susceptibles d'être contenus dans les puces n'ont pas été détaillés, les modes de réalisation décrits étant compatibles avec la plupart des circuits électroniques habituellement contenus dans des puces.

Dans la description qui suit, lorsque l'on fait référence à des qualificatifs de position absolue, tels que les termes "gauche", "droite", etc., ou relative, tels que les termes "supérieur", "inférieur", etc., ou à des qualificatifs d'orientation, tel que le terme "vertical", etc., il est fait référence à l'orientation des éléments concernés dans les figures. Sauf précision contraire, l'expression "de l'ordre de" signifie à 10 % près, de préférence à 5 % près.

Les figures 3A à 3F sont des vues en coupe d'étapes successives d'un mode de réalisation d'un procédé de fabrication d'une puce 25 isolée latéralement, du type de la puce 1 de la figure 1. La puce 25 est une puce destinée à être utilisée sans boitier. A titre d'exemple, la puce 25 comprend une diode identique à celle décrite en relation avec la figure 1. Dans ces figures, de mêmes éléments qu'en figure 1 sont désignés par de mêmes références.

Le procédé présenté ici permet l'individualisation de la puce 25 et l'isolation de ses faces latérales. Pour cela, une tranchée périphérique 33 entourant entièrement la puce 25 est gravée dans la tranche semiconductrice 29 dans laquelle la puce 25 est formée, puis la tranche 29 est amincie par sa face arrière pour individualiser la puce 25 en la séparant de la tranche 29.

A l'étape de la figure 3A, la diode est formée dans la tranche 29 puis la structure est masquée par une couche de masquage 31. La couche de masquage 31 est par exemple en résine ou composée d'une couche de dioxyde de silicium et d'une couche de résine. La couche de masquage 31 est gravée, par exemple par photolithographie, pour former un masque de gravure.

Par la suite, une tranchée 33 est gravée en suivant la forme imposée par la couche de masquage 31. La tranchée 33 est gravée à température ambiante à l'aide d'un faisceau d'ions. Ce faisceau d'ions est généré par un plasma de gravure d'hexafluorure de soufre (SF₆). Une gravure de ce type n'est que relativement anisotrope, c'est-à-dire qu'elle grave le silicium dans la direction verticale, mais qu'elle le grave aussi dans une moindre mesure dans la direction horizontale. Ainsi, la tranchée 33 a un fond relativement plat et des parois latérales plutôt arrondies. A cette étape, la tranchée n'est pas assez profonde pour former les parois latérales de la puce 25. La tranchée 33 a une profondeur comprise entre 50 et 250 µm, par exemple de l'ordre de 150 µm et une largeur comprise entre 5 et 80 µm, par exemple de l'ordre de 50 µm.

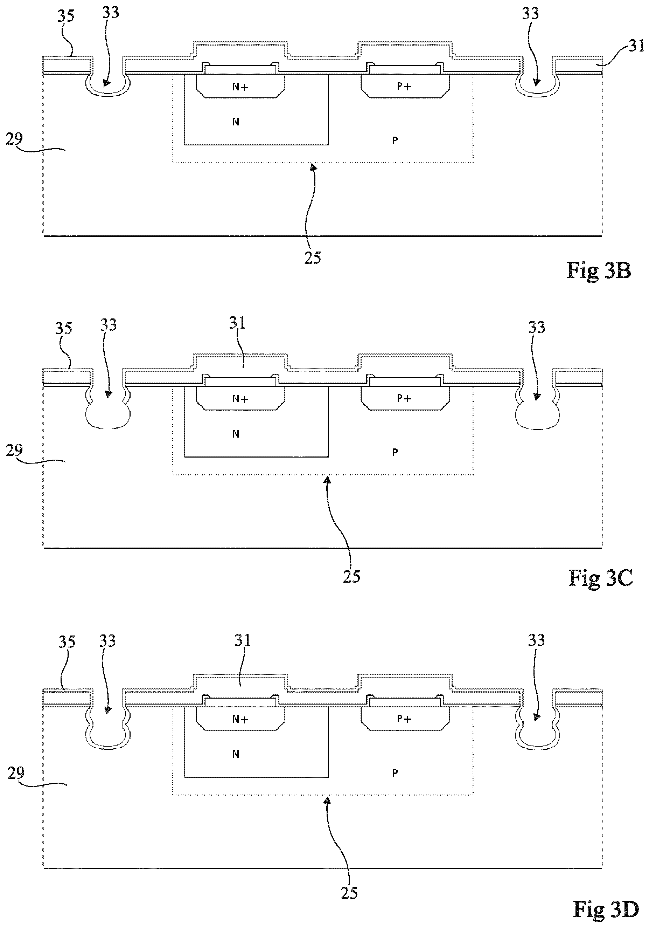

A l'étape de la figure 3B, la structure de la figure 3A est soumise à un plasma de passivation. Le plasma de passivation est par exemple un plasma de l'octafluorocyclobutane (C₄F₈). Le plasma de passivation forme une couche de passivation 35 isolante électriquement sur les parois de la tranchée 33. L'exposition au plasma de passivation a par exemple une durée comprise entre 1 et 7 s, de l'ordre de 3 s. Cette couche a pour but de protéger les parois latérales de la tranchée 33 lors d'une prochaine étape de gravure. La couche de passivation 35 est en un polyfluoroéthylène (CₓF_{y}). La couche de passivation 35 a une épaisseur par exemple comprise entre 50 et 100 nm, par exemple de l'ordre de 200 nm.

A l'étape de la figure 3C, la tranchée 33 est approfondie par une nouvelle gravure du même type que celle décrite en relation avec la figure 3A. Les parois latérales de la tranchée 33 étant protégées par la couche de passivation 35, seul le fond de la tranchée 33 est gravé. La partie nouvellement a une forme similaire à celle de la partie gravée décrite en figure 3A. La profondeur de la tranchée 33 a donc sensiblement doublé par rapport à celle de la figure 3A.

A l'étape de la figure 3D, la nouvelle tranchée 33 est soumise à un plasma de passivation. Cette étape est la même que celle décrite en relation avec la figure 3B. Elle permet à nouveau de protéger les parois latérales de la tranchée 33 pour des prochaines étapes de gravure.

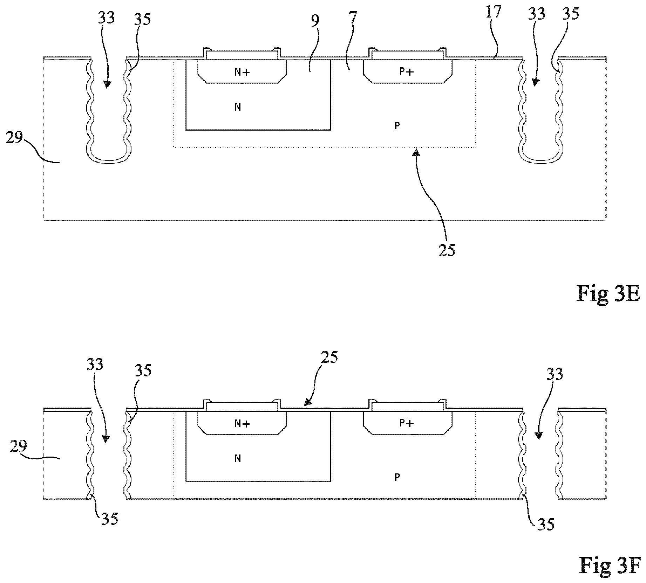

La figure 3E illustre l'état de la tranchée périphérique 33 après avoir réalisé successivement plusieurs étapes de gravure du type de celles décrites en relation avec les figures 3A et 3C et des étapes de passivation du type de celles décrites en relation avec les figures 3B et 3D jusqu'à ce que la tranchée 33 ait atteint une profondeur supérieure à l'épaisseur de la puce 25. Sur la figure 3E, le nombre d'étapes de gravure et de passivation représenté est arbitraire. La profondeur finale de la tranchée périphérique 33 est par exemple supérieure de 10 à 50 µm à l'épaisseur de la puce 25. La tranchée 33 reste toutefois non traversante, c'est-à-dire qu'elle ne s'étend pas jusqu'à la face inférieure de la tranche 29.

La dernière étape de passivation est plus longue que chacune des étapes de passivation précédentes. Cette étape a une durée comprise entre 10 s et 7 minutes, par exemple de l'ordre de 2 minutes afin de former une couche de polymère sur les faces de latérales de la diode ayant une épaisseur comprise entre 100 nm et 3 µm, par exemple de l'ordre de 1 µm.

La couche de masquage 31 est ensuite retirée, par exemple par gravure humide.

Dans l'état de la technique, à la fin d'un procédé de gravure de type procédé de gravure Bosch, on effectue une étape de nettoyage chimique, permettant de retirer la couche de passivation formée sur les parois de la tranchée car elle est considérée comme polluante. Cette couche est donc remplacée par une autre couche isolante, par exemple en oxyde de silicium.

Dans le procédé décrit ici, la couche de polymère est conservée pour isoler les faces latérales de la puce car il s'agit de la dernière des étapes d'un processus de fabrication et elle ne peut donc pas polluer d'autres étapes. Un avantage de ce procédé est de réduire son nombre d'étapes en supprimant au moins une étape de nettoyage et une étape de dépôt d'une nouvelle couche isolante.

A l'étape de la figure 3F, la tranche semiconductrice 29 est amincie par sa face inférieure. Un film adhésif de support (non représenté en figure 3F) est appliqué au préalable sur la face supérieure de l'assemblage afin d'assurer le maintien de la puce pendant l'étape d'amincissement. La tranche 29 est amincie par sa face arrière jusqu'à atteindre le fond de la tranchée 33 de façon à individualiser la puce 25 en la séparant du reste de la tranche 29. L'amincissement de la plaque ou tranche 29 est effectué par exemple par meulage de sa face arrière jusqu'à ce que la puce ait l'épaisseur désirée. Avant amincissement, la tranche semiconductrice 29 avait par exemple une épaisseur comprise entre 400 et 800 µm, par exemple de l'ordre de 600 µm. Après amincissement, la puce 25 a une épaisseur comprise entre 100 et 300 µm, par exemple de l'ordre de 150 µm.

La puce 25 peut ensuite être prélevée sur le film adhésif en vue de leur montage dans un dispositif électronique. La puce 25 a alors des parois latérales isolées électriquement par une couche de polyfluoroéthylène (CₓF_{y}).

Le présent mode de réalisation vise donc un procédé de gravure Bosch dans lequel on conserve et optimise la couche de polymère formée pendant les étapes de passivation.

Des modes de réalisation particuliers ont été décrits. Diverses variantes et modifications apparaîtront à l'homme de l'art. En particulier, le procédé a été décrit dans le cas d'une puce comprenant une diode mais il pourrait s'appliquer à une puce comprenant tout autre composant.

De plus, en pratique, une multitude de puces électroniques comprenant divers composants sont formées simultanément sur une même tranche semiconductrice.

## Revendications

1. Procédé de fabrication de puces isolées (25) latéralement à partir d'une tranche semiconductrice (29), comprenant les étapes successives suivantes :
former des tranchées périphériques (33) délimitant latéralement les puces à former (25), de profondeur supérieure ou égale à l'épaisseur des puces (25), en répétant des étapes successives de gravure ionique utilisant un plasma d'hexafluorure de soufre (SF6) et de passivation utilisant un plasma d'octafluorocyclobutane de façon que, à l'issue de l'étape de formation de la tranchée (33), les parois latérales de la tranchée (33) soient recouvertes d'une couche isolante d'un polyfluoroéthylène (35) ; et
amincir la tranche par sa face inférieure jusqu'à atteindre le fond de la tranchée (33) sans étape préalable de retrait de ladite couche isolante.

2. Procédé selon la revendication 1, dans lequel la dernière étape de passivation a une durée supérieure aux précédentes d'au moins 50 %.

3. Procédé selon la revendication 2, dans lequel la dernière étape de passivation a une durée comprise entre 10 s et 7 minutes.

4. Procédé selon l'une quelconque des revendications 1 à 3, dans lequel la couche isolante (35) a une épaisseur comprise entre 100 nm et 3 µm.

5. Procédé selon l'une quelconque des revendications 1 à 4, dans lequel la profondeur de la tranchée (33) est supérieure à l'épaisseur des puces de 10 à 50 µm.

6. Procédé selon l'une quelconque des revendications 1 à 5, dans lequel la tranchée (33) a une largeur comprise entre 5 et 80 µm.

7. Puce électronique (25) comprenant :
un substrat semiconducteur (29) ;
un ou plusieurs composants électroniques formés dans le substrat (29) ; et
une couche de polyfluoroéthylène (35) isolante d'épaisseur comprise entre 100 nm et 3 µm recouvrant les faces latérales de la puce.
